# FASCICULE DE BREVET EUROPEEN

(11) **EP 3 794 700 B1**
(45) Date de publication et mention de la délivrance du brevet: **20.08.2025**
(21) Numéro de dépôt: 19722149.2
(22) Date de dépôt: 10.05.2019
(51) Int. Cl.: H02H 3/08, H02H 7/122, H02H 7/22, H03K 17/0814, H03K 17/10

(54) **CIRCUIT DE PROTECTION D'UN INTERRUPTEUR**
SCHALTUNGSANORDNUNG ZUM SCHUTZ EINES SCHALTERS
CIRCUIT FOR PROTECTING A SWITCH

(30) Priorité: 17.05.2018 FR 1854142
(43) Date de publication de la demande: 24.03.2021
(73) Titulaire: Valeo Electrification, 95800 Cergy (FR)
(72) Inventeur: BEAUDOUX, Benoît, 75013 PARIS (FR)
(74) Mandataire: Valeo Powertrain Systems
(86) Numéro de dépôt international: PCT/EP2019/062049
(87) Numéro de publication internationale: WO 2019/219530

(56) Documents cités:
- FR-A1- 3 053 206
- US-A- 6 060 834
- US-A1- 2003 123 205

## Description

### DOMAINE TECHNIQUE ET OBJET DE L'INVENTION

La présente invention concerne un système électrique comprenant un interrupteur et des moyens électroniques de protection dudit interrupteur vis-à-vis de surcourants.

En particulier, la présente invention se rapport au domaine des véhicules automobiles notamment électriques ou hybrides. Plus précisément, dans le contexte d'un véhicule électrique ou hybride comprenant une batterie d'alimentation haute tension et une machine électrique pour la propulsion du véhicule, il est connu qu'un onduleur soit utilisé pour convertir un courant continu fourni par ladite batterie d'alimentation en une pluralité de courants alternatifs de commande de ladite machine électrique. La présente invention concerne, dans ce contexte, un équipement électrique, notamment de type onduleur, comprenant au moins un interrupteur et un dispositif de protection dudit interrupteur contre des surcourants, l'invention permettant audit dispositif de protection d'adapter la protection de l'interrupteur, en temps réel, en fonction de la température.

### ETAT DE LA TECHNIQUE

Comme cela est connu, les véhicules électriques embarquent des onduleurs, autrement dit convertisseurs de courant continu en courant alternatif polyphasé, en particulier triphasé, pour alimenter une machine électrique appartenant par exemple à un système de motorisation électrique ou hybride.

De tels onduleurs comprennent une pluralité de composants, dont des interrupteurs, qui doivent fonctionner sur une large plage de valeurs de température, par exemple variant de -40°C à + 105°C. Les interrupteurs, en particulier de type IGBT (pour " Insulated Gate Bipolar Transistor » signifiant transistor bipolaire à grille isolée), ou encore de type MOSFET (pour « Metal Oxide Semiconductor Field Effect Transistor» signifiant transistor à effet de champ à structure métal-oxyde-semiconducteur) sont contrôlés pour commander des transferts d'énergie entre une entrée et une sortie desdits convertisseurs.

De tels interrupteurs présentent une tension maximale admissible à leurs bornes, autrement dit une tension de claquage. Au-delà de ladite tension maximale admissible, lesdits interrupteurs peuvent être endommagés, voire détruits, rendant de ce fait l'onduleur inopérant.

Le document US6060834 décrit un circuit de protection contre les surtensions en fonction de la température d'un interrupteur d'un système électrique.

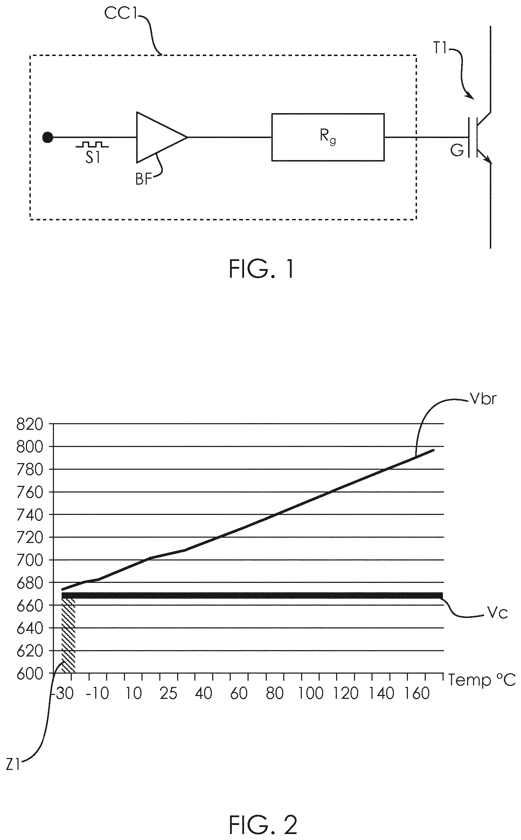

On a représenté à la figure 1 un exemple de circuit de contrôle CC1 d'un transistor T1 de type IGBT ou MOSFET. Dans un tel circuit, le signal de commande S1 du transistor T1 est fourni, par l'intermédiaire d'une unité de pilotage (ou «driver» en anglais) BF, à la grille G du transistor T1 à travers une résistance dite « de grille » Rg dont la valeur influence le fonctionnement du transistor. Plus précisément, lorsque la valeur de la résistance de grille Rg est faible, le transistor commute rapidement, ce qui permet d'obtenir de faibles pertes par commutation donc un bon rendement mais peut entraîner des surtensions (liées aux selfs parasites du circuit) pouvant détruire le composant et des niveaux de perturbation électromagnétique non conformes aux standards. A l'inverse, lorsque la valeur de la résistance de grille Rg est élevée, le transistor T1 commute moins vite, ce qui entraine des pertes élevées (en fermeture et ouverture) à cause des temps de commutations qui sont plus important, mais ceci permet d'obtenir des surtensions plus faibles et des niveaux de perturbation électromagnétique plus faibles. Ainsi, le choix de la résistance Rg optimale est un compromis entre les pertes, qui impactent le rendement, et les surtensions, qui peuvent conduire à la destruction du transistor T1 et à l'augmentation des niveaux de perturbation électromagnétique.

A températures élevées, par exemple de l'ordre de + 105°C, la tension de claquage d'un transistor IGBT ou MOSFET est généralement plus importante qu'à 25°C, température pour laquelle la tension de claquage est renseignée dans la fiche de données du composant. En revanche, à des températures basses, par exemple de l'ordre de - 40°C, la tension de claquage d'un transistor IGBT ou MOSFET est plus faible, de l'ordre de 5 à 7% de la tension de claquage à 25°C. De ce fait, une valeur faible de la résistance de grille Rg à température négative peut générer des surtensions dont la valeur serait supérieure à la tension de claquage, entrainant alors la destruction du transistor T1, rendant l'onduleur inopérant.

En résumé, la tension de claquage d'un interrupteur est dépendante de la température. En pratique, la tension maximale admissible aux bornes d'un interrupteur augmente ainsi avec la température.

Selon l'état de la technique, une solution à ce problème consiste à configurer le circuit de contrôle de tels interrupteurs de façon à ce qu'aucune tension supérieure à la tension de claquage ne soit appliquée aux bornes de l'interrupteur concerné. Ledit circuit de contrôle assure de fait alors une fonction de protection de l'interrupteur contre des surcourants. A cette fin, un seuil d'intensité maximale du courant, autorisé à traverser l'interrupteur, est prédéfini, en fonction de la tension de claquage Vbr et conformément au meilleur compromis déterminé selon les principes exposés précédemment. Dans l'état de l'art, ledit seuil Ve est constant, comme le montre la figure 2, de sorte que la zone de fonctionnement 21 dans laquelle l'interrupteur correspondant fonctionne de façon optimale est très réduite.

La tension de claquage d'un interrupteur étant plus faible à basse température, on se place donc, selon l'état de l'art, dans le pire cas d'utilisation envisagé, typiquement à -40 °C, pour fixer ledit seuil fixe.

Il existe donc un besoin pour un circuit de protection d'un interrupteur d'un convertisseur de tension, notamment d'un onduleur, qui permette d'optimiser le seuil de tension maximale admise aux bornes dudit interrupteur, tout en autorisant des commutations dudit interrupteur les plus rapides possibles, afin de minimiser les pertes sans dépasser la tension maximale admissible aux bornes dudit interrupteur, autrement dit sans dépasser l'intensité maximale du courant autorisé à traverser ledit interrupteur, et ceci quelle que soit la température.

### PRESENTATION GENERALE DE L'INVENTION

A cette fin, l'invention vise un circuit de protection d'un interrupteur d'un système électrique selon la revendication 1.

Notamment, l'interrupteur est un interrupteur électronique, en particulier un interrupteur semi-conducteur, tel qu'un transistor.

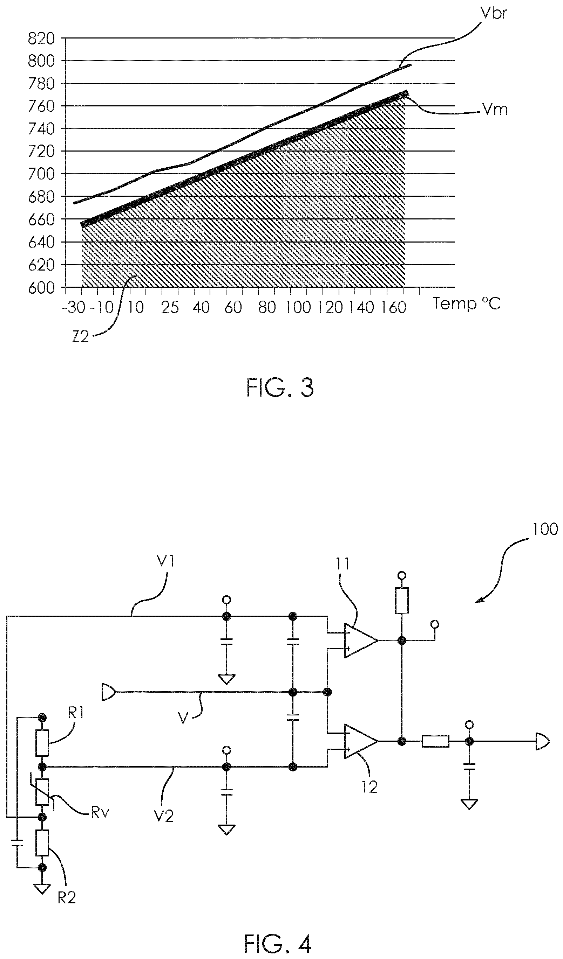

Grâce à la présente invention, la zone de fonctionnement optimale 22 de l'interrupteur protégé est étendue, en référence à la figure 3.

Selon un mode de réalisation, ledit composant électronique variable est une thermo-résistance.

Selon un mode de réalisation, ledit composant électronique variable est une thermo-résistance à coefficient thermique négatif.

Selon un mode de réalisation, ledit composant électronique variable est une thermo-résistance à coefficient thermique positif.

Selon un mode de réalisation, le circuit de protection comprend au moins une diode Zener configurée pour limiter premier seuil et/ou le deuxième seuil à une valeur absolue maximale.

La présente invention vise également un système électrique comprenant au moins un interrupteur présentant une tension maximale admissible à ses bornes dépendante de la température, comprenant un organe de coupure configuré pour interdire le passage, par une borne de l'interrupteur, d'un courant présentant une intensité supérieure à un seuil de courant, ledit système comprenant un circuit de protection tel que brièvement décrit ci-dessus, configuré pour commander l'organe de coupure.

La présente invention vise en outre un onduleur, notamment pour alimenter une machine électrique d'un système de motorisation d'un véhicule automobile électrique ou hybride, comprenant un système électrique tel que brièvement décrit ci-dessus.

### DESCRIPTION DES FIGURES

L'invention sera mieux comprise à la lecture de la description qui va suivre, donnée uniquement à titre d'exemple, et se référant aux dessins annexés qui représentent :
- la figure 1, le schéma d'un circuit de contrôle d'un transistor IGBT ou MOSFET selon l'état de la technique,
- la figure 2, le diagramme montrant un seuil fixe de protection en intensité d'un interrupteur, selon l'état de la technique,
- la figure 3, le diagramme montrant un seuil variable de protection en intensité d'un interrupteur, selon l'invention,
- la figure 4, un exemple de circuit de protection selon l'invention,
- la figure 5, un autre exemple de circuit de protection selon l'invention.

### DESCRIPTION DETAILLEE DE L'INVENTION

Il est rappelé que la présente invention est décrite ci-après à l'aide de différents modes de réalisation non limitatifs et est susceptible d'être mise en œuvre dans des variantes à la portée de l'homme du métier, également visées par la présente invention.

Dans ce qui suit, on vise en particulier une mise en œuvre du circuit de protection selon l'invention dans le contexte d'un onduleur de véhicule.

Dans l'exemple décrit ci-après, le véhicule comprend notamment une machine électrique, un équipement électrique se présentant sous la forme d'un onduleur, une batterie d'alimentation haute tension, un réseau électrique embarqué haute tension, une batterie d'alimentation basse tension, un réseau électrique embarqué basse tension et une pluralité d'équipements électriques auxiliaires.

L'équipement électrique selon l'invention est décrit ci-après dans sa mise en œuvre pour un onduleur, sans toutefois que cela ne limite la portée de la présente invention. On notera ainsi que l'équipement électrique pourrait être autre chose qu'un onduleur, par exemple un chargeur ou un convertisseur DCDC embarqués dans le véhicule.

Le réseau électrique embarqué basse tension relie la batterie d'alimentation basse tension et la pluralité d'équipements électriques auxiliaires afin que la batterie d'alimentation basse tension alimente lesdits équipements électriques auxiliaires, tels que des calculateurs embarqués, des moteurs de lève-vitres, un système multimédia, etc. La batterie d'alimentation basse tension délivre typiquement par exemple une tension de l'ordre de 12 V, 24 V ou 48 V. La recharge de la batterie basse tension est réalisée à partir de la batterie haute tension via un convertisseur de tension continue en tension continue, appelé communément convertisseur continu-continu.

Le réseau électrique embarqué haute tension relie la batterie d'alimentation haute tension et l'onduleur afin que la batterie d'alimentation haute tension assure une fonction d'alimentation en énergie de la machine électrique via l'onduleur. La batterie d'alimentation haute tension délivre typiquement une tension comprise entre 100 V et 900 V, de préférence entre 100 V et 500 V. La recharge en énergie électrique de la batterie d'alimentation haute tension est réalisée en la connectant, via le réseau électrique haute tension continue du véhicule, à un réseau électrique externe, par exemple le réseau électrique alternatif domestique.

La machine électrique est une machine électrique tournante, de préférence destinée à entrainer les roues du véhicule à partir de l'énergie fournie par la batterie d'alimentation haute-tension. Plus précisément, la machine électrique est une machine électrique à courant alternatif alimentée par une source de courants polyphasés. Par exemple, la machine électrique peut être un moteur à courant alternatif. Dans l'exemple préféré décrit ci-après, la machine électrique est alimentée par une source de courants triphasés sans que cela ne soit limitatif de la portée de la présente invention.

Dans cet exemple, la commande de la machine électrique est réalisée au moyen de l'onduleur. Ledit onduleur permet de convertir le courant continu fourni par la batterie d'alimentation haute tension en trois courants de commande alternatifs, par exemple sinusoïdaux. Autrement dit, l'onduleur a pour fonction de transformer le courant continu délivré en entrée par la batterie d'alimentation haute tension en trois courants de phase permettant de commander la machine électrique. A l'inverse, dans un autre mode de fonctionnement, la machine électrique peut également fournir trois courants alternatifs à l'onduleur afin que ledit onduleur les transforme en un courant continu permettant de charger la batterie d'alimentation haute-tension.

L'onduleur comprend un boîtier dans lequel sont montés des composants électroniques de puissance, par lesquels passe l'énergie alimentant la machine électrique, notamment destinés à transformer le courant continu en courants alternatifs ou vice-versa, et une unité de commande commandant lesdits composants électroniques de puissance.

Ces composants électroniques de puissance comprennent notamment des interrupteurs électroniques tels que des transistors, notamment des transistors semiconducteurs de type IGBT ou MOSFET, agencés en circuit électrique et commandés en ouverture et en fermeture par des circuits de contrôle pour permettre un passage commandé d'énergie électrique entre la batterie d'alimentation haute tension et la machine électrique.

L'unité électronique de contrôle de l'onduleur comprend des composants pour contrôler les composants électroniques de puissance, notamment les transistors. Plus précisément, l'unité électronique de contrôle commande les composants électroniques de puissance afin qu'ils réalisent la fonction de conversion du courant continu reçu de la batterie haute tension, définissant une tension continue, en trois courants de phase alternatifs de commande de la machine électrique (ou vice-versa).

Selon l'invention, il est proposé un circuit de protection desdits interrupteurs d'une unité de contrôle électronique d'un système électrique, notamment d'un onduleur.

Conformément à l'invention, comme le montre la figure 3, le seuil de tension maximale Vm autorisée aux bornes desdits interrupteurs du système électrique est adapté en temps réel en fonction de la température.

Par exemple, plus la température est basse, plus le seuil de tension maximale Vm autorisée aux bornes d'un interrupteur est réduite, et donc plus la puissance pouvant être transférée par ledit interrupteur est réduite.

Il est à noter que la diminution de la puissance maximale que l'interrupteur est apte à transférer implique une baisse de la puissance disponible pour la machine électrique alimentée par ledit convertisseur, mais il est précisé que les performances d'une machine électrique sont de toute façon généralement bridées à froid, car, à froid, le champ magnétique au stator de la machine électrique tournante considérée réduit les performances magnétiques du rotor à aimant permanant de ladite machine électrique.

Selon le même exemple, à chaud, à l'inverse, le seuil de tension maximale autorisée aux bornes de l'interrupteur peut être augmenté, permettant de transférer davantage de puissance à la machine électrique.

Grâce au circuit de protection selon l'invention, le seuil de tension maximale autorisée aux bornes de l'interrupteur est ainsi adapté en temps réel, de façon intrinsèque, c'est-à-dire sans intervention d'un logiciel notamment, en fonction de la température.

Autrement dit, le seuil d'intensité maximale du courant autorisé à traverser l'interrupteur évolue intrinsèquement en fonction de la température.

De manière classique, lorsque le seuil d'intensité maximale du courant autorisé à traverser l'interrupteur, correspondant à une intensité pour laquelle la tension de claquage ne peut pas être dépassée, est atteinte, un organe de coupure est commandé pour ouvrir le circuit afin de garantir que ledit courant ne traversera pas ledit interrupteur.

Cette limitation de la tension maximale autorisée aux bornes de l'interrupteur est réalisée, selon l'invention, par l'intermédiaire de moyens électroniques, autrement dit de moyens matériels (« hardware » selon le terme en anglais bien connu de l'homme de l'art, qui s'oppose à « software » signifiant « logiciel » ). La figure 4 montre un exemple de tel circuit de protection d'un interrupteur contre des surcourants, ledit circuit étant apte à adapter intrinsèquement, en l'espèce, deux seuils d'intensité maximale du courant autorisé à traverser l'interrupteur, l'un des seuils étant positif et l'autre négatif.

A cette fin, en référence à la figure 4, un composant électronique supplémentaire Rv est intégré au circuit de protection 100, ledit composant électronique supplémentaire Rv présentant une caractéristique électrique, notamment une résistance, qui varie en fonction de la température.

Le composant électronique supplémentaire, selon l'invention, est variable, c'est-à-dire qu'il présente une caractéristique physique dont la valeur évolue de façon significative d'au moins 10% en fonction de la température. Il est entendu que cette évolution de 10% de ladite caractéristique physique est obtenue sur une plage de températures de l'environnement dans lequel la machine électrique est susceptible d'être utilisée, soit, s'agissant d'un véhicule, une plage de températures allant de -50°C à +50°C.

Selon le mode de réalisation représenté sur la figure 4, ledit composant électronique variable est une thermo-résistance variable Rv. Par exemple, ladite thermo- résistance variable peut être de type NTC, pour « Negative Thermal Coefficient » signifiant coefficient thermique négatif, ou de type PTC, pour « Positive Thermal Coefficient » signifiant coefficient thermique positif.

Toujours en référence au mode de réalisation représenté sur la figure 4, au moins une thermo-résistance variable Rv, dont la valeur de la résistance évolue en fonction de la température, est ainsi connectée dans le circuit de protection 100.

Selon la forme de réalisation choisie, la thermo-résistance variable Rv coopère, en formant des ponts diviseurs de tension, avec les résistances fixes R1, R2 de façon à adapter les seuils de tension V1, V2 délivrés respectivement en entrée des comparateurs 11 et 12.

Dans l'exemple de la figure 4, le circuit de protection 100 d'un interrupteur contre des surcourants comprend ainsi trois résistances R1, R2, Rv, dont la thermo- résistance variable Rv, formant deux ponts diviseurs de tension connectés entre une masse électrique et, respectivement, une borne d'un premier et d'un deuxième comparateur 11, 12. La mise en œuvre de deux comparateurs 11, 12 permet de comparer une tension mesurée V fonction de l'intensité du courant traversant l'interrupteur à deux seuils V1, V2, l'un étant par exemple négatif V1 et l'autre positif V2.

Alternativement, il est à noter que le circuit de protection selon l'invention peut être mis en œuvre dans un contexte où un seul seuil de courant est analysé, au moyen d'un seul comparateur. Dans ce cas, seules deux résistances, dont la thermo-résistance variable Rv, sont connectées entre la masse électrique et une entrée du comparateur, pour comparer la tension fonction de l'intensité du courant traversant l'interrupteur à un seuil unique, positif ou négatif.

Les comparateurs 11, 12 comparent une tension V qui est fonction de l'intensité du courant traversant l'interrupteur protégé à chacun des deux seuils V1, V2 issus des ponts diviseurs de tension comprenant la thermo-résistance variable Rv. Lesdits seuils V1, V2 sont par conséquent intrinsèquement variables en fonction de la température.

En résumé, selon l'invention, on règle le seuil d'intensité maximale à compter duquel le circuit de protection commande à un organe de coupure d'ouvrir le circuit pour empêcher le courant de traverser l'interrupteur de sorte que, par exemple, ledit seuil augmente linéairement avec la température.

Cependant, il est bien entendu possible de réaliser un arrangement selon lequel le(s) seuil(s) de courant au(x)quel(s) le circuit de protection commande à un organe de coupure d'ouvrir le circuit pour empêcher le courant de traverser l'interrupteur, peu(ven)t évoluer différemment en fonction de la température.

Le seuil de courant peut ainsi diminuer avec la température, voire évoluer de façon non linéaire avec la température. Dans ce cas, par exemple, une ou plusieurs diodes Zener peut être ajoutée au circuit de coupure 100 de façon à limiter le seuil auquel le circuit de protection commande à un organe de coupure d'ouvrir le circuit pour empêcher le courant de traverser l'interrupteur, par exemple lorsque la température est élevée.

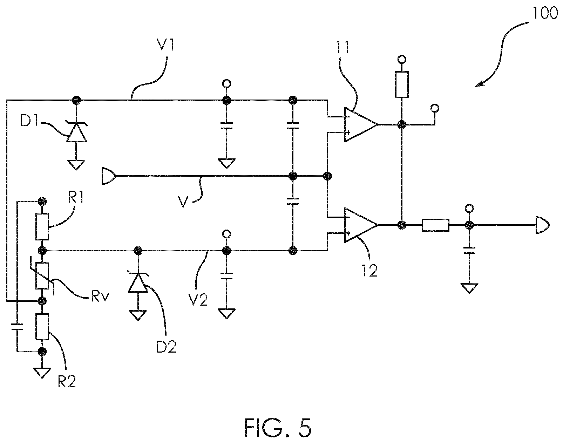

En référence à la figure 5, deux diodes Zener D1, D2 peuvent être connectées entre une masse électrique du circuit de coupure 101 et, respectivement, une borne du premier 11 et du deuxième 12 comparateurs à laquelle est connecté respectivement le seuil négatif V1 et le seuil positif V2 issus des ponts diviseurs formés des résistances R1, R2, Rv.

Les diodes Zener D1, D2 permettent de limiter les seuils V1, V2 auxquels est comparée la tension V mesurée qui est fonction de l'intensité du courant traversant l'interrupteur protégé.

## Revendications

1. Circuit de protection (100) d'un interrupteur d'un système électrique, ledit circuit de protection (100) comprenant un composant électronique variable (Rv) présentant une caractéristique physique dont la valeur évolue d'au moins 10% en fonction de la température, le circuit de protection (100) étant configuré pour interdire le passage d'un courant par ledit interrupteur lorsque l'intensité dudit courant dépasse un seuil d'intensité maximale autorisée, ledit composant électronique variable (Rv) étant connecté dans le circuit de protection (100) de telle sorte que la valeur du seuil d'intensité maximale autorisée soit directement fonction de ladite caractéristique physique, le circuit de protection étant **caractérisé en ce qu'**il comprend un premier comparateur (11) pour comparer une tension fonction du courant destiné à circuler dans l'interrupteur à un premier seuil de tension variable dépendant directement de la caractéristique physique du composant électronique variable (Rv) et un deuxième comparateur (12), pour comparer la tension fonction du courant destiné à circuler dans l'interrupteur à un deuxième seuil de tension variable dépendant directement de la caractéristique physique du composant électronique variable (Rv), le premier seuil étant positif et le deuxième seuil étant négatif.

2. Circuit de protection (100) selon la revendication 1, dans lequel ledit composant électronique variable (Rv) est une thermo-résistance.

3. Circuit de protection (100) selon la revendication 2, dans lequel ledit composant électronique variable (Rv) est une thermo-résistance à coefficient thermique négatif.

4. Circuit de protection (100) selon la revendication 2, dans lequel ledit composant électronique variable est une thermo-résistance (Rv) à coefficient thermique positif.

5. Circuit de protection (100) selon l'une des revendications précédentes, comprenant au moins une diode Zener configurée pour limiter le premier seuil et/ou le deuxième seuil à une valeur absolue maximale.

6. Système électrique comprenant au moins un interrupteur présentant une tension maximale admissible à ses bornes dépendante de la température, comprenant un organe de coupure configuré pour interdire le passage, par une borne de l'interrupteur, d'un courant présentant une intensité supérieure à un seuil de courant, ledit système comprenant un circuit de protection (100) selon l'une des revendications 1 à 5, configuré pour commander l'organe de coupure.

7. Onduleur, notamment pour alimenter une machine électrique d'un système de motorisation d'un véhicule automobile électrique ou hybride, comprenant un système électrique selon la revendication précédente.

## Patentansprüche

1. Schutzschaltung (100) für einen Schalter eines elektrischen Systems, wobei die besagte Schutzschaltung (100) ein variables elektronisches Bauelement (RV) umfasst, das eine physikalische Eigenschaft aufweist, deren Wert sich in Abhängigkeit von der Temperatur um mindestens 10% ändert, wobei die Schutzschaltung (100) konfiguriert ist, um den Durchgang eines Stroms durch den besagten Schalter zu verhindern, wenn die Intensität des besagten Stroms eine Schwelle der maximal zulässigen Stromstärke überschreitet, wobei das besagte variable elektronische Bauelement (Rv) in der Schutzschaltung (100) derart angeschlossen ist, dass der Wert der Schwelle der maximal zulässigen Stromstärke direkt von der besagten physikalischen Eigenschaft abhängt, wobei die Schutzschaltung **dadurch gekennzeichnet ist, dass** sie einen ersten Komparator (11) zum Vergleichen einer Spannung, die eine Funktion des Stroms ist, der durch den Schalter fließen soll, mit einer ersten variablen Spannungsschwelle, die direkt von der physikalischen Eigenschaft des variablen elektronischen Bauelements (Rv) abhängt, und einen zweiten Komparator (12) umfasst, zum Vergleichen der Spannung, die eine Funktion des Stroms ist, der durch den Schalter fließen soll, mit einer zweiten variablen Spannungsschwelle, die direkt von der physikalischen Eigenschaft des variablen elektronischen Bauelements (Rv) abhängt, wobei die erste Schwelle positiv und die zweite Schwelle negativ ist.

2. Schutzschaltung (100) nach Anspruch 1, bei der das besagte variable elektronische Bauelement (RV) ein Thermowiderstand ist.

3. Schutzschaltung (100) nach Anspruch 2, bei der das besagte variable elektronische Bauelement (RV) ein Thermowiderstand mit negativem Temperaturkoeffizienten ist.

4. Schutzschaltung (100) nach Anspruch 2, bei der das besagte variable elektronische Bauelement ein Thermowiderstand (Rv) mit positivem Temperaturkoeffizienten ist.

5. Schutzschaltung (100) nach einem der vorhergehenden Ansprüche, umfassend mindestens eine Zenerdiode, die konfiguriert ist, um die erste Schwelle und/oder die zweite Schwelle auf einen maximalen Absolutwert zu begrenzen.

6. Elektrisches System, umfassend mindestens einen Schalter, der eine maximal zulässige Spannung an seinen Anschlüssen aufweist, die von der Temperatur abhängt, umfassend ein Schaltelement, das konfiguriert ist, um den Durchgang eines Stroms mit einer Intensität, die größer als eine Stromschwelle ist, durch einen Anschluss des Schalters zu verhindern, wobei das besagte System eine Schutzschaltung (100) nach einem der Ansprüche 1 bis 5 umfasst, die konfiguriert ist, um das Schaltelement zu steuern.

7. Wechselrichter, insbesondere zur Versorgung einer elektrischen Maschine eines Antriebssystems eines Elektro- oder Hybridkraftfahrzeugs, umfassend ein elektrisches System nach dem vorhergehenden Anspruch.

## Claims

1. Protection circuit (100) for a switch of an electrical system, said protection circuit (100) comprising a variable electronic component (RV) having a physical characteristic whose value changes by at least 10% as a function of temperature, the protection circuit (100) being configured to prevent the passage of a current through said switch when the intensity of said current exceeds a maximum authorized current threshold, said variable electronic component (Rv) being connected in the protection circuit (100) such that the value of the maximum authorized current threshold is directly a function of said physical characteristic, the protection circuit being **characterized in that** it comprises a first comparator (11) for comparing a voltage that is a function of the current intended to flow through the switch with a first variable voltage threshold directly dependent on the physical characteristic of the variable electronic component (Rv) and a second comparator (12), for comparing the voltage that is a function of the current intended to flow through the switch with a second variable voltage threshold directly dependent on the physical characteristic of the variable electronic component (Rv), the first threshold being positive and the second threshold being negative.

2. Protection circuit (100) according to claim 1, wherein said variable electronic component (RV) is a thermistor.

3. Protection circuit (100) according to claim 2, wherein said variable electronic component (RV) is a thermistor with a negative thermal coefficient.

4. Protection circuit (100) according to claim 2, wherein said variable electronic component is a thermistor (Rv) with a positive thermal coefficient.

5. Protection circuit (100) according to one of the preceding claims, comprising at least one Zener diode configured to limit the first threshold and/or the second threshold to a maximum absolute value.

6. Electrical system comprising at least one switch having a maximum admissible voltage across its terminals dependent on temperature, comprising a switching element configured to prevent the passage, through a terminal of the switch, of a current having an intensity greater than a current threshold, said system comprising a protection circuit (100) according to one of claims 1 to 5, configured to control the switching element.

7. Inverter, notably for supplying power to an electric machine of a propulsion system of an electric or hybrid motor vehicle, comprising an electrical system according to the preceding claim.
